# EUROPEAN PATENT APPLICATION

(11) **EP 4 815 098 A1**
(43) Date of publication of application: **30.09.2026**
(21) Application number: 24896671.5
(22) Date of filing: 28.11.2024
(51) Int. Cl.: H01M 10/42, G01R 31/36, G01R 31/327

(54) **BATTERY MANAGEMENT SYSTEM, BATTERY PACK, AND ELECTRICAL APPARATUS**

(30) Priority: 30.11.2023 CN 202311641752
(71) Applicant: Contemporary Amperex Technology Co., Limited, Ningde, Fujian 352100 (CN)
(72) Inventor: CHEN, Hui, Ningde, Fujian 352100 (CN); YE, Fuming, Ningde, Fujian 352100 (CN)
(74) Representative: Ziebig Hengelhaupt Intellectual Property Attorneys Patentanwaltskanzlei PartGmbB
(86) International application number: PCT/CN2024/135385
(87) International publication number: WO 2025/113586

(57) **Abstract**

The present disclosure provides a battery management system, a battery pack, and a power consuming apparatus. The battery management system includes: a plurality of switch assemblies, each switch assembly being connected between a battery (40) and a corresponding load, and configured to connect the battery (40) to the corresponding load or disconnect the battery (40) from the corresponding load; a sampling circuit, the sampling circuit including sampling branches in a one-to-one correspondence with the plurality of switch assemblies, and each sampling branch being configured to acquire a voltage at a sampling detection point (Sd); a reference voltage module (10), configured to supply a first reference voltage to a reference sampling point (Rs); and a sampling module (30), configured to obtain a voltage of each sampling detection point (Sd) with respect to the reference sampling point (Rs), where when the plurality of switch assemblies further include switch assemblies connected in parallel, the sampling branches include two first sampling branches (20), one of the first sampling branches (20) is connected to one end of the switch assemblies connected in parallel, and the other first sampling branch (20) is connected to the other end of the switch assemblies connected in parallel.

## Description

### CROSS-REFERENCE TO RELATED APPLICATIONS

The present disclosure claims priority to Chinese patent application No. 202311641752.1, filed with the China National Intellectual Property Administration on November 30, 2023, and entitled "SAMPLING CIRCUIT, BATTERY MANAGEMENT SYSTEM, BATTERY PACK, AND POWER CONSUMING APPARATUS", which is incorporated herein by reference in its entirety.

### TECHNICAL FIELD

The present disclosure relates to the field of power management technologies, and in particular, to a battery management system, a battery pack, and a power consuming apparatus.

### BACKGROUND

With the development of new energy technologies, batteries are being increasingly widely used in various power consuming apparatuses such as mobile phones, laptop computers, electric scooters, electric vehicles, electric aircraft, and electric ships.

During the operation of a power consuming apparatus, a power supply can supply power to various power consuming units to maintain the normal operation of the power consuming units. A plurality of relay switches are typically disposed in high-voltage lines corresponding to the positive and negative electrodes of the battery. To ensure the reliability of the battery during use, voltage sampling needs to be performed at various detection points within the battery, enabling corresponding execution and processing based on sampling results.

However, circuit designs for voltage sampling in related technologies are complex and costly.

### SUMMARY

Embodiments of the present disclosure provide a battery management system, a battery pack, and a power consuming apparatus, to optimize the circuit design of a sampling circuit, thereby improving the operational reliability of a battery.

According to a first aspect, embodiments of the present disclosure provide a battery management system, the battery management system including:
a plurality of switch assemblies, each switch assembly being connected between a battery and a corresponding load, and configured to connect the battery to the corresponding load or disconnect the battery from the corresponding load;
a sampling circuit, the sampling circuit including sampling branches in a one-to-one correspondence with the plurality of switch assemblies, and each sampling branch being configured to acquire a voltage at a sampling detection point, where a first end of each sampling branch is connected to a corresponding switch assembly, and a connection point is the sampling detection point; a second end of each sampling branch is connected to a reference voltage module, and a connection point is a reference sampling point; and a third end of each sampling branch is connected to a sampling module;
the reference voltage module, configured to supply a first reference voltage to the reference sampling point; and
the sampling module, configured to obtain a voltage of each sampling detection point with respect to the reference sampling point, where
when the plurality of switch assemblies further include switch assemblies connected in parallel, the sampling branches include two first sampling branches, one of the first sampling branches is connected to one end of the switch assemblies connected in parallel, and the other first sampling branch is connected to the other end of the switch assemblies connected in parallel.

The reference voltage module is disposed to supply the first reference voltage to the reference sampling point, so that the first sampling branch can be used to sample the voltage of the sampling detection point with respect to the reference sampling point. The sampling module may determine the voltage of each sampling detection point with respect to the reference sampling point, to implement voltage sampling on sampling detection points with different voltages. In addition, when a plurality of sampling detection points are provided, through the sharing of the same reference sampling point, a potential difference between any two sampling detection points may be calculated based on potential differences of the two sampling detection points with respect to the reference sampling point, thereby implementing circuit detection between the sampling detection points. In addition, when at least two switch assemblies are connected in parallel, the at least one switch assembly may further multiplex the same group of first sampling branches, thereby further simplifying the circuit design and reducing circuit costs.

In a possible implementation of the first aspect, the sampling module is connected to a high-voltage ground. The sampling module is connected to the high-voltage ground, so that the issue of insulation withstand voltage no longer needs to be considered for the sampling module, and the voltage withstand rating selection for a switch device is relatively flexible. In addition, the sampling circuit belongs to a high-voltage region, and is no longer connected to a low voltage. In addition, interference immunity can be improved, and an isolation device does not need to be disposed, thereby reducing costs.

In a possible implementation of the first aspect, the reference voltage module includes: a voltage source, the voltage source being configured to supply a second reference voltage; and a voltage conversion module, connected to the voltage source, and configured to convert the second reference voltage of the voltage source to provide corresponding sampling ranges for sampling detection points with different reference voltage requirements, respectively. The voltage source is disposed to supply the second reference voltage, and then the second reference voltage is converted into different first reference voltages using the voltage conversion module, so that each sampling detection point can be sampled with respect to the first reference voltage or the second reference voltage, thereby satisfying different sampling requirements.

In a possible implementation of the first aspect, the first reference voltage is less than the second reference voltage. The first reference voltage is set to be less than the second reference voltage, so that large sampling ranges can be separately provided for a sampling detection point with a high voltage and a sampling detection point with a low voltage, thereby ensuring the accuracy of a sampling result.

In a possible implementation of the first aspect, the voltage source is connected to a second terminal of the battery, and the second reference voltage is a voltage of an output voltage of the voltage source with respect to the second terminal of the battery. The second terminal of the battery is used as a reference ground, so that the voltage source can supply the first reference voltage with respect to the second terminal of the battery to the reference sampling point.

In a possible implementation of the first aspect, the sampling branches further include: a second sampling branch, connected to a first terminal of the battery and the voltage source, the voltage source being configured to supply the first reference voltage to the second sampling branch, where the sampling module is connected to a third end of the second sampling branch, and is configured to obtain a voltage at the first terminal of the battery with respect to the second terminal of the battery. The second sampling branch can sample the voltage at the first terminal of the battery with respect to the second terminal of the battery, to directly obtain the terminal voltage of the battery, thereby implementing voltage sampling of the battery.

In a possible implementation of the first aspect, the voltage conversion module includes: a first voltage division unit, the first voltage division unit being connected between the voltage source and the reference sampling point; and a voltage regulation unit, the voltage regulation unit being connected to the reference sampling point. The first voltage division unit and the voltage regulation unit are disposed, so that the second reference voltage that is high can be clamped to output the first reference voltage that is low.

In a possible implementation of the first aspect, the voltage conversion module further includes a second voltage division unit connected in parallel to the voltage regulation unit. The second voltage division unit can implement a voltage division function with the first voltage division unit, so that the voltage at the reference sampling point is kept from being excessively high when an abnormality, for example, an open circuit, occurs in the voltage regulation unit.

In a possible implementation of the first aspect, the sampling branch includes: a first sampling unit and a second sampling unit, the first sampling unit and the second sampling unit being connected in series. The first sampling unit and the second sampling unit divide the voltage at the sampling detection point, so that the terminal voltage of the second sampling unit can fall within a sampling range of the sampling module.

In a possible implementation of the first aspect, the sampling branch includes a first sampling point, and the sampling module includes a first sampling end; the first sampling point is disposed between the first sampling unit and the second sampling unit; and the first sampling point is connected to the first sampling end of the sampling module. In a conventional sampling manner with the arrangement that the first sampling end of the sampling module is connected to the first sampling point of the sampling branch, the voltage at the middle point between the first sampling unit and the second sampling unit can be directly sampled, and the voltage of the sampling detection point with respect to the reference sampling point can be determined with reference to a voltage division ratio of the first sampling unit to the second sampling unit.

In a possible implementation of the first aspect, the sampling branch includes a second sampling point, and the sampling module includes a second sampling end; the second sampling point is disposed at two ends of the second sampling unit; and the second sampling point is connected to the second sampling end of the sampling module. In a differential sampling manner with the arrangement that the second sampling end of the sampling module is connected to the second sampling point of the sampling branch, so that the terminal voltage of the second sampling unit can be directly sampled, and the voltage of the sampling detection point with respect to the reference sampling point can be determined with reference to a voltage division ratio of the first sampling unit to the second sampling unit.

In a possible implementation of the first aspect, the second sampling end of the sampling module is a differential sampling end. The terminal voltage of the second sampling unit can be directly obtained through differential sampling.

In a possible implementation of the first aspect, the sampling branch further includes: a sampling control switch, the sampling control switch being connected between the first sampling unit and the second sampling unit, where the sampling control switch is configured to enable the sampling branch to be connected or disconnected. The sampling control switch can open the sampling branch when voltage sampling is not required, thereby saving resources.

In a possible implementation of the first aspect, the plurality of switch assemblies include at least one first switch assembly and/or at least one second switch assembly, and the sampling branches include: a first terminal sampling branch, disposed corresponding to the first switch assembly, a sampling detection point corresponding to the first terminal sampling branch being connected to the first terminal of the battery by the first switch assembly; and a second terminal sampling branch, disposed corresponding to the second switch assembly, a sampling detection point corresponding to the second terminal sampling branch being connected to the second terminal of the battery by the second switch assembly. The first terminal sampling branch and the second terminal sampling branch may perform voltage sampling on a sampling detection point with a positive voltage and a sampling detection point with a negative voltage, respectively, and sampled voltages at the sampling detection points may be obtained, thereby implementing voltage sampling of a high-voltage loop.

In a possible implementation of the first aspect, the first switch assembly includes any one of a main positive switch, a pre-charging switch, a main positive direct current charging switch, and a main positive alternating current charging switch, and the second switch assembly includes any one of a main negative switch and a main negative charging switch. Voltage sampling is performed at each sampling detection point, and whether a sticking fault or another problem occurs on the switches may further be detected based on a sampling result, thereby implementing state diagnosis for the switch assemblies.

According to a second aspect, the embodiments of the present disclosure provide a battery pack, including a battery and the battery management system provided in any embodiment of the first aspect.

According to a third aspect, the embodiments of the present disclosure provide a power consuming apparatus, including the battery pack provided in any embodiment of the second aspect.

Compared with the related technologies, according to the battery management system, the battery pack, and the power consuming apparatus provided in the embodiments of the present disclosure, the reference voltage module is disposed to supply the first reference voltage to the reference sampling point, so that the first sampling branch can be used to sample the voltage of the sampling detection point with respect to the reference sampling point. The sampling module may determine the voltage of each sampling detection point with respect to the reference sampling point, to implement voltage sampling on sampling detection points with different voltages. In addition, when a plurality of sampling detection points are provided, through the sharing of the same reference sampling point, a potential difference between any two sampling detection points may be calculated based on potential differences of the two sampling detection points with respect to the reference sampling point, thereby implementing circuit detection between the sampling detection points. In addition, when at least two switch assemblies are connected in parallel, the at least one switch assembly may further multiplex the same group of first sampling branches, thereby further simplifying the circuit design and reducing circuit costs.

### BRIEF DESCRIPTION OF THE DRAWINGS

To describe the technical solutions of the embodiments of the present disclosure more clearly, the following briefly describes the accompanying drawings required for the embodiments of the present disclosure. Apparently, the accompanying drawings in the following description show only some embodiments of the present disclosure, and persons of ordinary skill in the art may still derive other drawings from these accompanying drawings without creative efforts.
FIG. 1 is a schematic diagram of a modular structure of a sampling circuit according to an embodiment of the present disclosure;
FIG. 2 is a schematic diagram of a modular structure of a sampling circuit according to another embodiment of the present disclosure;
FIG. 3 is a schematic diagram of a modular structure of a sampling circuit according to yet another embodiment of the present disclosure;
FIG. 4 is a schematic diagram of a modular structure of a sampling circuit according to still another embodiment of the present disclosure;
FIG. 5 is a schematic diagram of a modular structure of a sampling circuit according to still another embodiment of the present disclosure;
FIG. 6 is a schematic diagram of a modular structure of a sampling circuit according to still another embodiment of the present disclosure;
FIG. 7 is a schematic diagram of a circuit structure of a sampling circuit according to an embodiment of the present disclosure;
FIG. 8 is a schematic diagram of a circuit structure of a conventional sampling manner according to an embodiment of the present disclosure; and
FIG. 9 is a schematic diagram of a circuit structure of a differential sampling manner according to an embodiment of the present disclosure.

In the accompanying drawings:
10. reference voltage module; 20. first sampling branch; 30. sampling module; 40. battery; 50. second sampling branch; 11. voltage source; 12. voltage conversion module; 121. first voltage division unit; 122. voltage regulation unit; 123. second voltage division unit; 21. first terminal sampling branch; 22. second terminal sampling branch; 23. first sampling unit; 24. second sampling unit; 25. sampling control switch; Rs. reference sampling point; Sd. sampling detection point; GND-R. reference ground; Ps. first sampling point; Ns. second sampling point; 61. first switch assembly; 62. second switch assembly; K1. main negative switch; K2. main positive switch; K3. pre-charging switch; K4. main positive direct current charging switch; K5. main negative charging switch; and K6. main positive alternating current charging switch.

### DETAILED DESCRIPTION

The features and exemplary embodiments of various aspects of the present disclosure are described below in detail. To make the objectives, technical solutions, and advantages of the present disclosure clearer and more comprehensible, the following further describes the present disclosure in detail with reference to the accompanying drawings and specific embodiments. It should be understood that the specific embodiments described herein are provided only for describing the present disclosure rather than limiting the present disclosure. Persons skilled in the art may implement the present disclosure without some of these specific details. The following descriptions of the embodiments are merely intended to provide a better understanding of the present disclosure by showing examples of the present disclosure.

It should be noted that the relational terms herein such as first and second are used only to differentiate an entity or operation from another entity or operation, and do not require or imply any actual relationship or sequence between these entities or operations. Moreover, the terms "include", "comprise", or any variation thereof are intended to cover a non-exclusive inclusion. Therefore, in the context of a process, method, object, or device that includes a series of elements, the process, method, object, or device not only includes such elements, but also includes other elements not specified expressly, or may include inherent elements of the process, method, object, or device. If no more limitations are made, an element limited by "include ..." does not exclude other same elements existing in the process, the method, the article, or the device which includes the element.

It should be noted that the embodiments in the present disclosure and the features in the embodiments may be combined with each other without causing any conflict. The embodiments are described below in detail with reference to the accompanying drawings.

With the development of new energy technologies, batteries are being increasingly widely used in various power consuming apparatuses such as mobile phones, laptop computers, electric scooters, electric vehicles, electric aircraft, and electric ships.

During the operation of a power consuming apparatus, a power supply can supply power to various power consuming units to maintain the normal operation of the power consuming units. A plurality of relay switches are typically disposed in high-voltage lines corresponding to a first terminal and a second terminal of the battery. To ensure the reliability of the battery during use, voltage sampling needs to be performed at various detection points within the battery, enabling corresponding execution and processing based on sampling results.

However, the circuit architecture for voltage sampling in related technologies has some defects.

To resolve the foregoing technical problems, embodiments of the present disclosure provide a sampling circuit, a battery management system, a battery pack, and a power consuming apparatus. The following first describes the sampling circuit provided in the embodiments of the present disclosure.

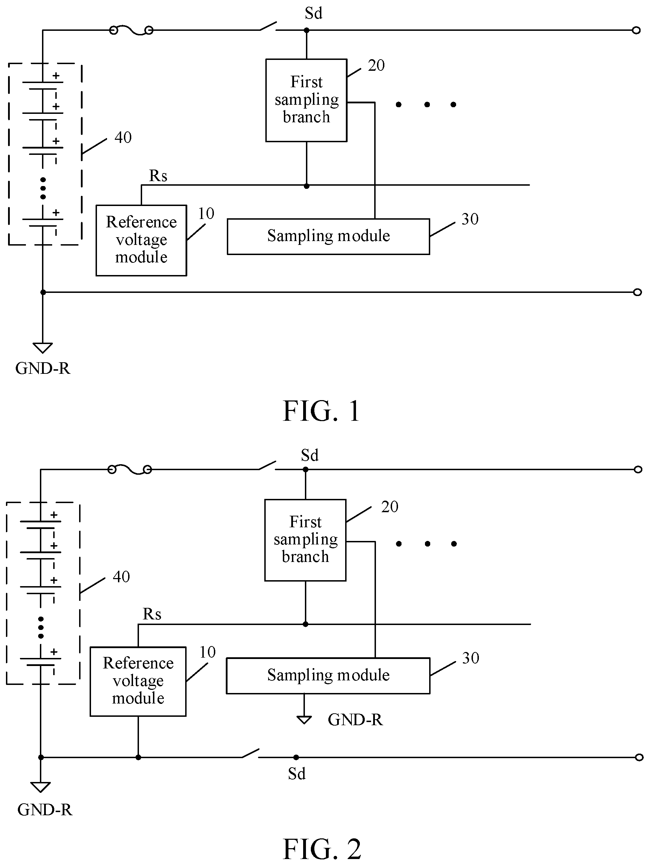

According to some embodiments of the present disclosure, referring to FIG. 1, the present disclosure provides a sampling circuit. The sampling circuit includes a reference voltage module 10, a first sampling branch 20, and a sampling module 30.

The reference voltage module 10 is connected to a reference sampling point Rs. The reference voltage module 10 may supply a first reference voltage to the reference sampling point Rs, so that a voltage of the reference sampling point Rs with respect to a reference ground GND-R is the first reference voltage.

An example in which a voltage source 11 maintains the first reference voltage at 2.5 V is used. If a voltage of the reference ground GND-R is 0 V, the voltage source 11 can enable a voltage at the reference sampling point Rs to be 2.5 V. If a voltage of the reference ground GND-R with respect to the ground is 10 V, the voltage source 11 can enable the voltage at the reference sampling point Rs to be 12.5 V.

The first sampling branch 20 may be connected between a corresponding sampling detection point Sd in a battery 40 and the reference sampling point Rs. The first sampling branch 20 may perform voltage sampling on a voltage at the sampling detection point Sd.

A sampling end of the sampling module 30 may be connected to the first sampling branch 20. The sampling module 30 may determine a voltage at the sampling detection point Sd corresponding to the first sampling branch 20 with respect to the reference sampling point Rs based on a sampled signal received by the sampling end from the first sampling branch 20.

It may be understood that the sampling module 30 has a corresponding sampling range, and a voltage of a sampled signal that can be acquired by the sampling module 30 should fall within the sampling range. When the sampling module 30 uses the reference ground GND-R as a 0 voltage reference, the first reference voltage that is supplied by the reference voltage module 10 to the reference ground GND-R and that is based on the reference ground GND-R is used as a bias voltage of the sampling module 30. Therefore, the first reference voltage should be within the sampling range of the sampling module 30, so that the sampled signal obtained by the sampling module 30 does not exceed the sampling range of the sampling module 30.

In a plurality of sampling detection points Sd, potential differences between some sampling detection points Sd and the reference ground GND-R are positive values, and potential differences between other sampling detection points Sd and the reference ground GND-R are negative values.

In the related technologies, generally, when a negative electrode of the battery 40 is used as the reference ground GND-R, and the negative electrode of the battery 40 is used as a sampling reference of the sampling module 30, for some sampling detection points Sd whose voltage is higher than the reference ground GND-R, the sampling module 30 can normally perform sampling, to obtain voltages of the sampling detection points Sd with respect to the reference ground GND-R. However, for the other sampling detection points Sd whose voltage is lower than the reference ground GND-R, the sampling module 30 cannot normally perform sampling. That is, in the related technologies, because a sampling port of a sampling chip can acquire only a positive voltage, some sampling detection points Sd whose voltage is lower than a voltage at the negative electrode of the battery 40 cannot be sampled. For example, as shown in FIG. 2, the reference voltage module 10 may be connected to a second terminal of the battery 40, to use the second terminal of the battery 40 as the reference ground GND-R. In this case, for a sampling detection point Sd whose voltage may be lower than that of the second terminal of the battery 40 and that is located on an outer side of a main negative relay, voltage sampling cannot be implemented. Consequently, a voltage sampling requirement of the battery 40 cannot be met.

In this embodiment of the present disclosure, when the second terminal of the battery 40 may be selected as the reference ground GND-R, the reference ground may also be referred to as a "high-voltage ground". FIG. 2 is used as an example. The sampling module 30 may be connected to the high-voltage ground GND-R. The high-voltage ground GND-R may be a reference ground supplied by a high-voltage system. For example, the high-voltage system may be a battery system. It should be noted that in the field, an operating voltage of the battery system falls under Class B. For example, a maximum operating voltage is between 60 V and 1500 V, and therefore is defined as the high-voltage system. In this case, a reference ground supplied by the second terminal (that is, a negative electrode of the battery 40) of the battery 40 may be generally referred to as the high-voltage ground GND-R.

It should be further noted that the sampling module 30 is connected to the high-voltage ground GND-R. In this case, the issue of insulation withstand voltage no longer needs to be considered, and the voltage withstand rating selection for a switch device is relatively flexible. In addition, sampling circuits are in a high-voltage region, and are not connected to a low voltage, so that no impact of common-mode interference exists, and interference immunity is better. In addition, no isolation device needs to be disposed, so that costs can be reduced. It should be noted that FIG. 2 is used as an example herein to describe that the sampling module 30 is connected to the high-voltage ground GND-R, but this is not limited thereto. In other drawings, the sampling module 30 is also connected to the high-voltage ground GND-R.

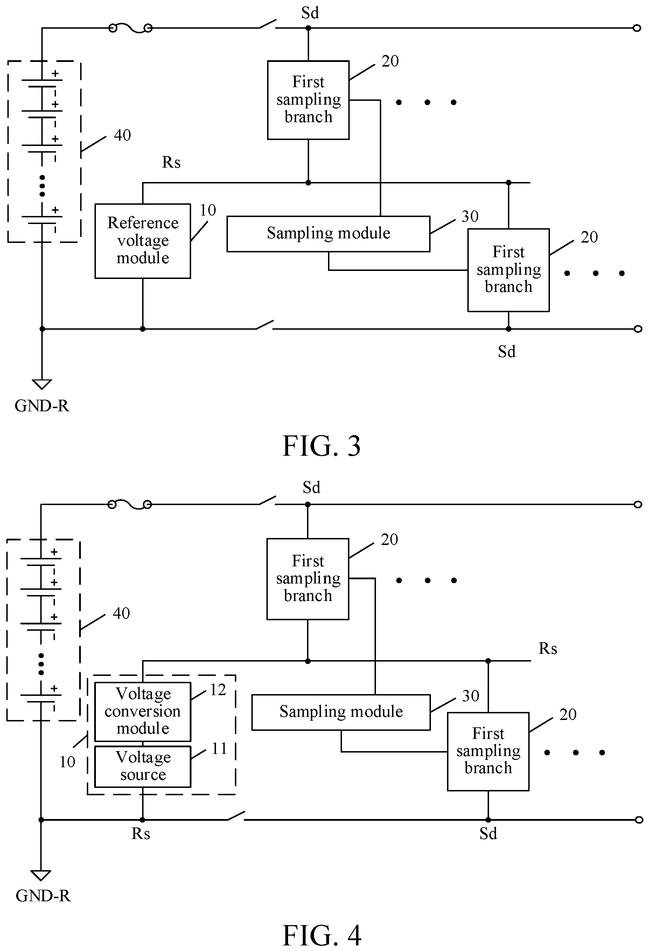

In the foregoing embodiment, referring to FIG. 3, for the plurality of sampling detection points Sd, a plurality of first sampling branches 20 that respectively correspond to the plurality of sampling detection points Sd may be disposed, and each first sampling branch 20 is connected between a corresponding sampling detection point Sd and the reference sampling point Rs. A plurality of sampling ends of the sampling module 30 are respectively connected to the plurality of first sampling branches 20. The sampling module 30 may obtain a voltage of each corresponding sampling detection point Sd with respect to the reference sampling point Rs by using each sampling end, and then perform voltage sampling of the plurality of sampling detection points Sd with respect to the reference ground GND-R in combination with the first reference voltage between the reference sampling point Rs and the reference ground GND-R.

Because the first reference voltage is maintained between the reference sampling point Rs and the reference ground GND-R, for some sampling detection points Sd whose voltage is higher than the reference ground GND-R, the sampling module 30 can normally perform voltage sampling of the sampling detection points Sd. For other sampling detection points Sd whose voltage is lower than the reference ground GND-R, because the first reference voltage is higher than voltages at the sampling detection points Sd, the sampling module 30 can obtain potential differences between the reference sampling point Rs and the sampling detection points Sd by acquiring a positive voltage, and further determine voltages of the sampling detection points Sd with respect to the reference ground GND-R based on the first reference voltage between the reference sampling point Rs and the reference ground GND-R, thereby implementing a negative-voltage sampling function.

After a potential difference of each sampling detection point Sd with respect to the reference sampling point Rs is obtained, a potential difference between any two sampling detection points Sd may be calculated based on potential differences of the two sampling detection points Sd with respect to the reference sampling point Rs.

In this embodiment, the reference voltage module 10 is disposed to supply the first reference voltage to the reference sampling point Rs, so that the first sampling branch 20 can be used to sample the voltage of the sampling detection point Sd with respect to the reference sampling point Rs. The sampling module 30 may determine the voltage of each sampling detection point Sd with respect to the reference sampling point Rs, to implement voltage sampling on sampling detection points Sd with different voltages. In addition, when a plurality of sampling detection points Sd are provided, through the sharing of the same reference sampling point Rs, a potential difference between any two sampling detection points Rd may be calculated based on potential differences of the two sampling detection points Rd with respect to the reference sampling point Rs, thereby implementing circuit detection between the sampling detection points Rd.

According to some embodiments of the present disclosure, referring to FIG. 4, the reference voltage module 10 may include a voltage source 11 and a voltage conversion module 12.

The voltage source 11 may supply a second reference voltage. The voltage conversion module 12 may be connected to the voltage source 11, and convert the second reference voltage output by the voltage source 11 into the first reference voltage.

The voltage conversion module 12 may be connected between the voltage source 11 and the reference sampling point Rs. The voltage conversion module 12 may receive the second reference voltage supplied by the voltage source 11, and perform voltage conversion on the second reference voltage to obtain the first reference voltage.

The second reference voltage and the first reference voltage may be set based on the sampling range of the sampling module 30. For example, the second reference voltage is set to a maximum range voltage of the sampling module 30. In this case, the voltage conversion module 12 may perform step-down conversion on the second reference voltage to obtain the first reference voltage lower than the second reference voltage. When the sampling module 30 performs voltage sampling, the resistance of the voltage division resistors in the first sampling branch 20 may be properly set, so that when the sampling module 30 performs voltage sampling on a sampling detection point Sd whose voltage with respect to the reference ground GND-R is positive, a voltage range of an acquired sampled signal is between the first reference voltage and the maximum range voltage. When voltage sampling is performed on a sampling detection point Sd whose voltage with respect to the reference ground GND-R is negative, a voltage range of an acquired sampled signal is between the first reference voltage and a minimum range voltage. That is, the voltage at the reference sampling point Rs is set as the first reference voltage, so that the sampling module 30 can implement voltage sampling on a sampling detection point Sd with a positive voltage and a sampling detection point Sd with a negative voltage.

The voltage source 11 is disposed to supply the second reference voltage, and then the second reference voltage is converted into the first reference voltage using the voltage conversion module 12, so that each sampling detection point can be sampled with respect to the first reference voltage or the second reference voltage, to respectively provide corresponding sampling ranges for sampling detection points with different reference voltage requirements, thereby meeting different sampling requirements.

According to some embodiments of the present disclosure, the first reference voltage may be less than the second reference voltage. That is, the voltage conversion module 12 performs a step-down function, and converts the second reference voltage that is high into the first reference voltage that is low.

In some examples, the first reference voltage may be half of the second reference voltage. For example, when the second reference voltage is 5 V, it indicates that a potential difference between an output voltage of the voltage source 11 and the reference ground GND-R is 5 V. In this case, the first reference voltage may be set to half of the second reference voltage, that is, 2.5 V, and it indicates that a potential difference between the reference sampling point Rs and the reference ground GND-R is 2.5 V.

An example in which a maximum sampling range of the sampling module 30 is 5 V is used. When a voltage at a sampling detection point Sd is higher than the reference ground GND-R, sampling and voltage division may be performed on a voltage between the sampling detection point Sd and the reference sampling point Rs using a corresponding first sampling branch 20. The resistance of the resistors in the corresponding first sampling branch 20 is adjusted, so that a voltage output by a sampling end of the first sampling branch 20 after the division does not exceed the maximum sampling range of the sampling module 30. In this case, the sampling module 30 uses the reference ground GND-R as the reference, and the divided voltage output by the first sampling branch 20 should be at least higher than a voltage of the reference sampling point Rs with respect to the reference ground GND-R. That is, the voltage output by the sampling end of the first sampling branch 20 is between 2.5 V and 5 V.

When a voltage at a sampling detection point Sd is lower than the reference ground GND-R, a similar manner may alternatively be used. The first sampling branch 20 may perform sampling and voltage division on a voltage between the reference sampling point Rs and the sampling detection point Sd. It may be understood that in this case, the divided voltage output by the first sampling branch 20 is a positive voltage, and the positive voltage is lower than the voltage of the reference sampling point Rs with respect to the reference ground GND-R. That is, the voltage output by the sampling end of the first sampling branch 20 is between 0 V and 2.5 V.

The sampling detection point Sd whose voltage is higher than the reference ground GND-R is a sampling detection point Sd with a positive voltage, and the sampling detection point Sd whose voltage is lower than the reference ground GND-R is a sampling detection point Sd with a negative voltage. For both the sampling detection point Sd with a positive voltage and the sampling detection point Sd with a negative voltage, the sampling module 30 can perform voltage sampling by using the first sampling branch 20, and calculate the voltages of the sampling detection points Sd with respect to the reference sampling point Rs.

According to some embodiments of the present disclosure, continuing to refer to FIG. 4, the second terminal of the battery 40 may be selected as the reference ground GND-R. The voltage source 11 may be connected to the second terminal of the battery 40. The second reference voltage supplied by the voltage source 11 is a difference between the output voltage of the voltage source 11 and a voltage at the second terminal of the battery 40.

In this embodiment, the second terminal of the battery 40 is used as the reference ground GND-R, so that a voltage of the output voltage of the voltage source 11 with respect to the second terminal of the battery 40 is the second reference voltage. The second reference voltage may be converted into the first reference voltage using the voltage conversion module 12, so that a voltage of the reference sampling point Rs with respect to the second terminal of the battery 40 is the first reference voltage.

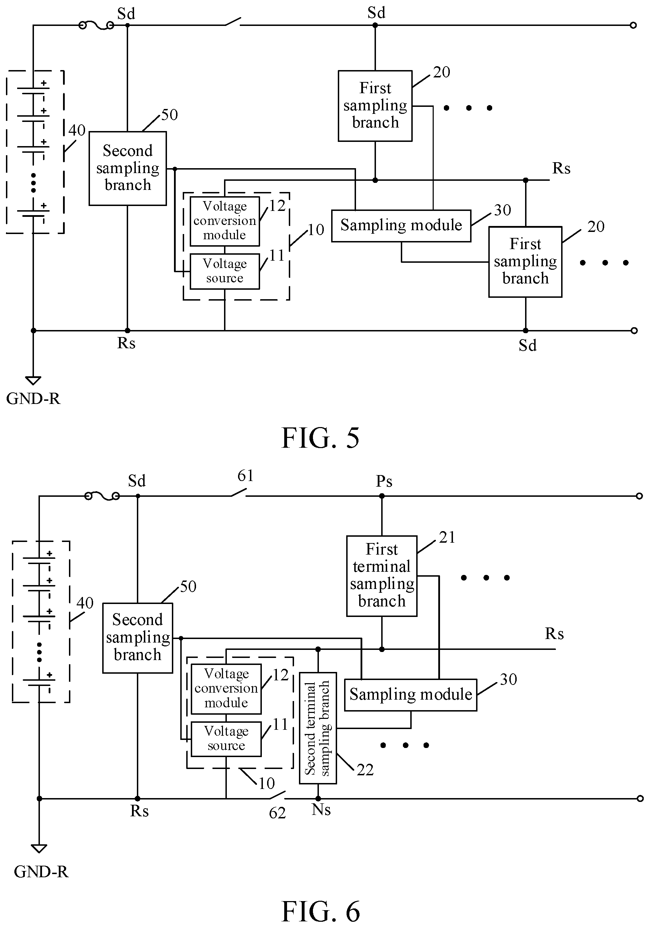

According to some embodiments of the present disclosure, referring to FIG. 5, the sampling circuit may further include a second sampling branch 50.

The second sampling branch 50 may be connected to a first terminal of the battery 40 and the voltage source 11. The voltage source 11 may supply the first reference voltage as a bias voltage to the second sampling branch 50.

The second sampling branch 50 may perform sampling and voltage division on a voltage at the first terminal of the battery 40, and use the second reference voltage output by the voltage source 11 as the bias voltage, so that a sampled signal output by the second sampling branch 50 meets the sampling range of the sampling module 30.

One of the sampling ends of the sampling module 30 may be connected to a sampling end of the second sampling branch 50, and obtains a divided sampled signal output by the second sampling branch 50. The sampling module 30 may calculate a voltage at the first terminal of the battery 40 with respect to the reference ground GND-R based on the sampled signal. Because the reference ground GND-R is the second terminal of the battery 40, the voltage calculated by the sampling module 30 is the terminal voltage of the battery 40.

Referring to FIG. 6, the plurality of sampling detection points Sd may include a first sampling point Ps and a second sampling point Ns.

The first sampling point Ps may be a sampling detection point Sd connected to the first terminal of the battery 40 by a first switch assembly 61, and the second sampling point Ns may be a sampling detection point Sd connected to the second terminal of the battery 40 by a second switch assembly 62.

One first sampling point Ps in the plurality of sampling detection points Sd is used as an example. The first sampling point Ps is connected to the first terminal of the battery 40 by the first switch assembly 61. When the first switch assembly 61 is normally turned on, a voltage at the first sampling point Ps is kept consistent with the voltage at the first terminal of the battery 40. When the first switch assembly 61 is turned off, the voltage at the first sampling point Ps is different from the voltage at the first terminal of the battery 40. Therefore, after the first switch assembly 61 is controlled to be turned off, the sampling module 30 may obtain a voltage between the first terminal of the battery 40 and the reference ground GND-R, that is, the second terminal of the battery 40, and perform voltage sampling on the first sampling point Ps by using the first sampling branch 20 corresponding to the first sampling point Ps and the sampling module 30. A sampling result generated by the sampling module 30 is a voltage of the first sampling point Ps with respect to the reference sampling point Rs. A voltage of the first sampling point Ps with respect to the reference ground GND-R may be determined in combination with the first reference voltage between the reference sampling point Rs and the reference ground GND-R. Whether a fault such as sticking occurs after the first switch assembly 61 is opened can be determined by comparing the voltage between the first terminal and the second terminal of the battery 40 with a voltage of the first sampling point Ps with respect to the second terminal of the battery 40.

In an optional implementation, the foregoing manner of performing sticking detection on the first switch assembly 61 may be determining whether a difference between the voltage at the first terminal of the battery 40 with respect to the reference ground GND-R and the voltage of the first sampling point Ps with respect to the reference ground GND-R is less than a preset voltage threshold. If the difference between the sampled voltages at the two sampling points is less than the preset voltage threshold, it may be determined that sticking occurs on the first switch assembly 61 and fails to open normally. If the difference between the sampled voltages at the two sampling points is greater than the preset voltage threshold, it may be determined that the first switch assembly 61 is normally turned off.

One second sampling point Ns in the plurality of sampling detection points Sd is used as an example. The sampling module 30 determines a voltage of the second sampling point Ns with respect to the reference sampling point Rs based on a sampled signal output by the first sampling branch 20. Subsequently, for any first sampling point Ps, it can be determined that a potential difference of the first sampling point Ps with respect to the second sampling point Ns is a difference between the voltage of the first sampling point Ps with respect to the reference sampling point Rs and the voltage of the second sampling point Ns with respect to the reference sampling point Rs. That is, a voltage of any first sampling point Ps with respect to a second sampling point Ns can be obtained based on a voltage of the second sampling point Ns with respect to the reference sampling point Rs, so that any second sampling point Ns can be used as a reference point, thereby implementing voltage sampling of a plurality of reference points.

According to some embodiments of the present disclosure, continuing to refer to FIG. 6 again, the first sampling branch may include a first terminal sampling branch 21 and/or a second terminal sampling branch 22.

A sampling detection point corresponding to the first terminal sampling branch 21 is the first sampling point Ps, and a sampling detection point corresponding to the second terminal sampling branch 22 is the second sampling point Ns. The first sampling point Ps may be connected to the first terminal of the battery 40 by the first switch assembly 61, and the second sampling point Ns may be connected to the second terminal of the battery 40 by the second switch assembly 62.

When the plurality of sampling detection points Sd include the first sampling point Ps, the first terminal sampling branch 21 corresponding to the first sampling point Ps may be set, and the first terminal sampling branch 21 may sample the voltage of the first sampling point Ps with respect to the reference sampling point Rs.

Similarly, when the plurality of sampling detection points Sd include the second sampling point Ns, the second terminal sampling branch 22 corresponding to the second sampling point Ns may be set, and the second terminal sampling branch 22 may sample the voltage of the second sampling point Ns with respect to the reference sampling point Rs.

When the plurality of sampling detection points include the first sampling point Ps and the second sampling point Ns, the corresponding first terminal sampling branch 21 and the corresponding second terminal sampling branch 22 may be disposed, respectively, to sample the voltage of the first sampling point Ps with respect to the reference sampling point Rs and sample the voltage of the second sampling point Ns with respect to the reference sampling point Rs, respectively. The first terminal sampling branch 21 and the second terminal sampling branch 22 may perform voltage sampling on a sampling detection point with a positive voltage and a sampling detection point with a negative voltage, respectively, and sampled voltages at the sampling detection points Sd may be obtained, thereby implementing voltage sampling of a high-voltage loop.

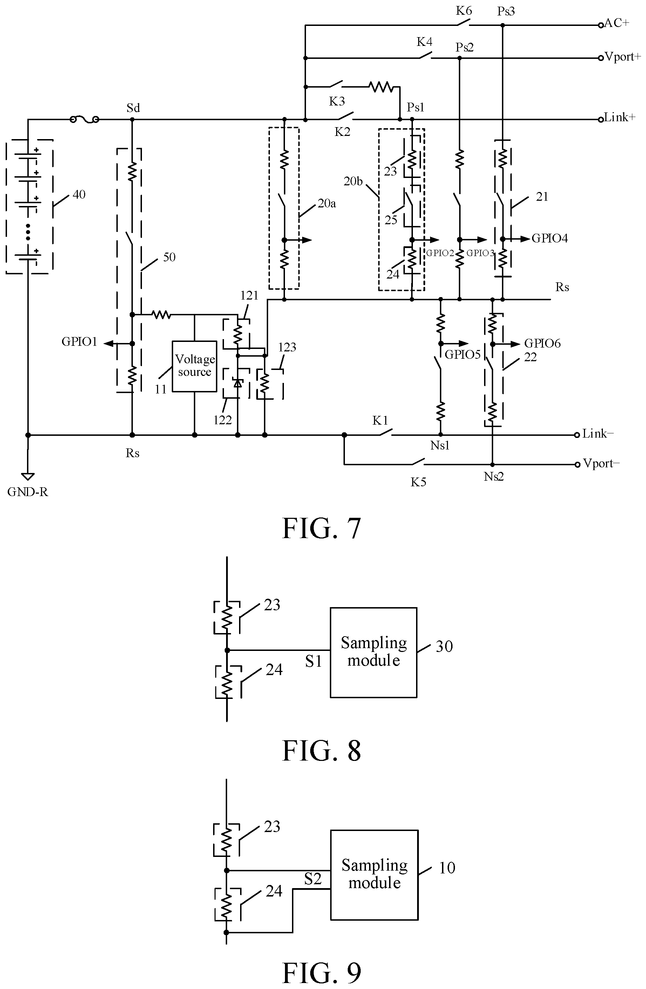

Continuing to refer to FIG. 7, according to some embodiments of the present disclosure, the voltage conversion module 12 may include a first voltage division unit 121 and a voltage regulation unit 122.

The first voltage division unit 121 is connected between the voltage source 11 and the reference sampling point Rs. The voltage regulation unit 122 is connected to the reference sampling point Rs. A breakdown voltage of the voltage regulation unit 122 is the first reference voltage.

After being divided by the first voltage division unit 121, the second reference voltage output by the voltage source 11 is still greater than the second reference voltage. In this case, the voltage regulation unit 122 can achieve a voltage regulation function, and limits a divided voltage of the first voltage division unit 121 to the first reference voltage.

The first voltage division unit 121 may perform a voltage division protection function, to prevent the voltage source 11 from being directly connected to the voltage regulation unit 122. In this case, a terminal voltage of the first voltage division unit 121 is a difference between the second reference voltage and the first reference voltage.

According to some embodiments of the present disclosure, the voltage conversion module 12 may further include a second voltage division unit 123 connected to the voltage regulation unit 122 in parallel.

The first voltage division unit 121 and the second voltage division unit 123 may form a voltage division circuit. When the voltage regulation unit 122 is disconnected, the resistance of the first voltage division unit 121 and the second voltage division unit 123 is properly set, so that a divided voltage of the second voltage division unit 123 may be enabled to be the first reference voltage. In this case, a voltage between the reference sampling point Rs and the reference ground GND-R can still be maintained at the first reference voltage.

In some examples, the first voltage division unit 121 and the second voltage division unit 123 may be resistors, and the voltage regulation unit 122 may be a voltage regulating diode.

In another optional implementation, the voltage conversion module 12 may further include, but is not limited to, a direct current-direct current (DC-DC) conversion module, a low dropout regulator (LDO), or another device or chip that can convert the second reference voltage into the first reference voltage.

According to some embodiments of the present disclosure, referring to FIG. 7, the first sampling branch 20 may include a first sampling unit 23 and a second sampling unit 24.

The first sampling unit 23 and the second sampling unit 24 are connected in series.

The first sampling unit 23 and the second sampling unit 24 may be respectively formed by resistors. The number and resistance of the resistors in the first sampling unit 23 and the second sampling unit 24 may be set based on a normal voltage range of the sampling detection point Sd to which the first sampling branch 20 is connected. For example, when the terminal voltage of the battery 40 is relatively high, if the normal voltage range of the sampling detection point Sd includes a high voltage, a resistor with high resistance may be disposed for the first sampling unit 23, and a resistor with low resistance may be disposed for the second sampling unit 24, so that after the first sampling unit 23 and the second sampling unit 24 divide the voltage at the sampling detection point Sd, a voltage difference between two ends of the second sampling unit 24 is kept from being excessively large and exceeding a detection range of the sampling module 30, and is also kept from being excessively small and affecting the accuracy of a sampling result.

According to some embodiments of the present disclosure, referring to FIG. 8, the sampling module 30 may include a first sampling end S1, the first sampling branch 20 may include a first sampling point, and the first sampling point is disposed in the middle of the first sampling unit 23 and the second sampling unit 24.

The first sampling point of the first sampling branch 20 may be connected to the first sampling end S1 of the sampling module 30, and the sampling module 30 may obtain a voltage at the first sampling point through the first sampling end S1.

After obtaining the voltage at the first sampling point through the first sampling point, the sampling module 30 may determine the voltage difference between the two ends of the first sampling branch 20 based on the equivalent resistance of the first sampling unit 23 and the second sampling unit 24.

According to some embodiments of the present disclosure, referring to FIG. 9, the sampling module 30 may include a second sampling end S2, the first sampling branch 20 may include a second sampling point, and the second sampling point is disposed on two sides of the second sampling unit 24. That is, the second sampling point includes at least two sampling points on the two sides of the second sampling unit 24.

The second sampling point of the first sampling branch 20 may be connected to the second sampling end S2 of the sampling module 30, and the sampling module 30 may obtain a voltage at the second sampling point through the second sampling end S2. When two second sampling points are provided, two second sampling ends S2 of the sampling module 30 are also provided.

The sampling module 30 may directly sample the terminal voltage of the second sampling unit 24 through the second sampling end S2. After the terminal voltage of the second sampling unit 24 is determined, the voltage difference between the two ends of the first sampling branch 20 may be calculated based on the equivalent resistance of the first sampling unit 23 and the second sampling unit 24.

According to some embodiments of the present disclosure, the second sampling end S2 of the sampling module 30 may be a differential sampling end, that is, the second sampling end S2 may perform differential sampling on the two ends of the second sampling unit 24, to obtain a voltage difference between the two ends of the second sampling unit 24.

The sampling module 30 may be a sampling chip, and a sampling manner of the sampling chip may be differential sampling, or may be conventional sampling.

When the sampling manner of the sampling chip is differential sampling, the sampling end corresponding to the first sampling branch 20 is the second sampling end S2, and the second sampling end S2 includes a positive sampling end and a negative sampling end. The positive sampling end should be connected to one of the two ends of the second sampling unit 24 in the first sampling branch 20 that has a higher voltage, and the negative sampling end should be connected to one of the two ends of the second sampling unit 24 that has a lower voltage.

When the first sampling branch 20 is the first terminal sampling branch 21, an intermediate voltage of the first sampling unit 23 and the second sampling unit 24 is greater than the voltage at the reference sampling point Rs. In this case, the positive sampling end in the second sampling end S2 should be connected to the middle of the first sampling unit 23 and the second sampling unit 24, and the negative sampling end is connected to the other end of the second sampling unit 24.

In contrast, when the first sampling branch 20 is the second terminal sampling branch 22, the intermediate voltage of the first sampling unit 23 and the second sampling unit 24 is less than the voltage at the reference sampling point Rs. In this case, the negative sampling end in the second sampling end S2 should be connected to the middle of the first sampling unit 23 and the second sampling unit 24, and the positive sampling end is connected to the other end of the second sampling unit 24.

It should be noted that the sampling chip may include a plurality of second sampling ends S2. When the plurality of sampling detection points need to be detected in the sampling circuit, each second sampling end S2 may be connected to the corresponding first sampling branch 20.

According to some embodiments of the present disclosure, continuing to refer to FIG. 7, the first sampling branch 20 may further include a sampling control switch 25. The sampling control switch 25 may be connected between the first sampling unit 23 and the second sampling unit 24.

The sampling control switch 25 may be switched between an on state and an off state, to connect and disconnect the first sampling branch 20. In addition, when the sampling control switch 25 is turned off, the first sampling branch 20 is disconnected, and in this case, the sampling module 30 cannot obtain the sampled signal.

When a sampling detection point Sd requires voltage sampling, the sampling control switch 25 in the first sampling branch 20 corresponding to the sampling detection point Sd may be controlled to be turned on, and when voltage sampling is not required, the sampling control switch 25 may be controlled to be turned off.

A circuit architecture of the second sampling branch 50 may be the same as or similar to that of the first sampling branch 20, and details are not described herein again.

According to some embodiments of the present disclosure, the sampling module 30 may be connected to a sampling control switch 25, and the sampling module 30 may control the sampling control switch 25 to be turned on or turned off.

The sampling module may include a sampling chip, the sampling chip may further include a switch control end, and the switch control end may be connected to the sampling control switch 25 to control the on state of the sampling control switch 25. When the sampling function needs to be enabled, the sampling chip may send a turn-on signal to the sampling control switch 25, so that the sampling control switch 25 connects the first sampling unit 23 to the second sampling unit 24.

According to some embodiments of the present disclosure, the sampling control switch 25 may include, but is not limited to, one of a transistor, an optoelectronic device, and a relay. The sampling control switch 25 may alternatively be another switch device or switch equipment that can implement on-off control.

According to some embodiments of the present disclosure, referring to FIG. 7, the first switch assembly 61 may include any one of a main positive switch K2, a pre-charging switch K3, a main positive direct current charging switch K4, and a main positive alternating current charging switch K6, and the second switch assembly 62 may include any one of a main negative switch K1 and a main negative charging switch K5.

The main negative switch K1 is used as an example. A sampling point connected to the second terminal of the battery 40 by the main negative switch K1 is a second sampling point Ns1. A sampling module 30 corresponding to the second sampling point Ns1 can obtain a voltage of the second sampling point Ns1 with respect to the reference sampling point Rs. After another sampling module 30 obtains a voltage of any first sampling point Ps with respect to the reference sampling point Rs, the another sampling module 30 may calculate, based on a difference between the two voltages, a voltage of any first sampling point Ps with respect to the second sampling point Ns1, to obtain a voltage at each first sampling point Ps when the second sampling point Ns1 is used as a reference.

As shown in FIG. 7, GPIO1 to GPIO6 are respectively a plurality of sampling ends of the sampling module 30. The sampling ends are respectively connected to a corresponding first sampling branch 20 or second sampling branch 50, to perform voltage sampling on each sampling detection point Sd.

In an optional implementation, a first sampling point Ps1 corresponding to the main positive switch K2 is used as an example. When the first reference voltage is 2.5 V, a voltage of the first sampling point Ps1 with respect to the reference sampling point Rs is: ${U}_{Ps 1} = \left(U_GPIO2-2.5\right) / Ra * \left(Ra+Rb\right) .$

U_GPIO2 is a voltage acquired by using a GPIO2 port of the sampling module 30, Ra is the equivalent resistance of the second sampling unit 24 in the corresponding first sampling branch 20, and Rb is the equivalent resistance of the first sampling unit 23.

Similarly, the voltage of the second sampling point Ns1 with respect to the reference sampling point Rs is: ${U}_{Ns 1} = \left(U_GPIO5-2.5\right) / Ra * \left(Ra+Rb\right) .$

U_GPIO5 is a voltage acquired by using a GPIO5 port of the sampling module 30.

After the voltage UPs1 of the first sampling point Ps1 with respect to the reference sampling point Rs and the voltage UNs1 of the second sampling point Ns1 with respect to the reference sampling point Rs are calculated, a voltage of the first sampling point Ps1 with respect to the second sampling point Ns1 may be calculated as follows: ${U}_{Ps 1 - Ns 1} = {U}_{Ps 1} - {U}_{Ns 1} = \left(U_GPIO2-U_GPIO5\right) / Ra * \left(Ra+Rb\right) .$

It can be known from the foregoing analysis that, after the voltage of any first sampling point with respect to the reference sampling point Rs is determined, the voltage of the first sampling point with respect to the second sampling point Ns1 can be calculated, thereby implementing voltage sampling using the second sampling point Ns1 as the reference point.

Similarly, a sampling point connected to the second terminal of the battery 40 by the main negative charging switch K5 may be a second sampling point Ns2. In a manner similar to that in the foregoing embodiment, the voltage at each first sampling point Ps when the second sampling point Ns is used as the reference can be obtained. That is, the second terminal of the battery 40, the second sampling point Ns1, and the second sampling point Ns2 may all be used as reference points, to obtain the voltages of each first sampling point Ps with respect to the reference points.

Based on the same inventive concept, the present disclosure further provides a battery management system. The battery management system includes the sampling circuit in any one of the foregoing embodiments. It may be understood that the battery management system has beneficial effects of the sampling circuit provided in the embodiments of the present disclosure. For details, refer to specific descriptions of the sampling circuit in the foregoing embodiments. Details are not described herein again in this embodiment.

According to some embodiments of the present disclosure, the battery management system may include:
a plurality of switch assemblies, each switch assembly being connected between a battery and a corresponding load, and configured to connect the battery to the corresponding load or disconnect the battery from the corresponding load;
a sampling circuit, the sampling circuit including sampling branches in a one-to-one correspondence with the plurality of switch assemblies, and each sampling branch being configured to acquire a voltage at a sampling detection point, where a first end of each sampling branch is connected to a corresponding switch assembly, and a connection point is the sampling detection point; a second end of each sampling branch is connected to a reference voltage module, and a connection point is a reference sampling point; and a third end of each sampling branch is connected to a sampling module;
the reference voltage module, configured to supply a first reference voltage to the reference sampling point; and
the sampling module, configured to obtain a voltage of each sampling detection point with respect to the reference sampling point, where
when the plurality of switch assemblies further include switch assemblies connected in parallel, the sampling branches include two first sampling branches, one of the first sampling branches is connected to one end of the switch assemblies connected in parallel, and the other first sampling branch is connected to the other end of the switch assemblies connected in parallel.

In this embodiment of the present disclosure, the reference voltage module is disposed to supply the first reference voltage to the reference sampling point, so that the first sampling branch can be used to sample the voltage of the sampling detection point with respect to the reference sampling point. The sampling module may determine the voltage of each sampling detection point with respect to the reference sampling point, to implement voltage sampling on sampling detection points with different voltages. In addition, when a plurality of sampling detection points are provided, through the sharing of the same reference sampling point, a potential difference between any two sampling detection points may be calculated based on potential differences of the two sampling detection points with respect to the reference sampling point, thereby implementing circuit detection between the sampling detection points. In addition, when at least two switch assemblies are connected in parallel, the at least one switch assembly may further multiplex the same group of first sampling branches, thereby further simplifying the circuit design and reducing circuit costs.

In this embodiment of the present disclosure, the same group of first sampling branches may include first sampling branches that are respectively disposed at two ends of switch assemblies connected in parallel, and the switch assemblies connected in parallel may mean that at least two switch assemblies are connected in parallel. For example, FIG. 7 is used as an example. The at least two switch assemblies connected in parallel may include a switch assembly in which the main positive switch K2 is located and a switch assembly in which the pre-charging switch K3 is located. One end of the two switch assemblies is connected to a first sampling branch 20a, and the other end of the two switch assemblies is connected to a first sampling branch 20b, thereby implementing multiplexing of the sampling branches.

It should be noted that besides a corresponding switch, the switch assembly may further include another device. This is not limited herein. For example, for the switch assembly in which the pre-charging switch K3 is located, the switch assembly may be considered as including the pre-charging switch K3 and a precharge resistor connected in series.

It should be further noted that in this embodiment of the present disclosure, a sampling detection point corresponding to the first sampling branch 20a is directly connected to the first terminal of the battery 40, and a sampling detection point corresponding to the first sampling branch 20b is connected to the first terminal of the battery 40 by the switch assemblies connected in parallel (including, for example, the switch assembly in which the main positive switch K2 is located and the switch assembly in which the pre-charging switch K3 is located), respectively. After a voltage difference between the two sampling detection points corresponding to the first sampling branch 20a and the first sampling branch 20b is calculated, the voltage difference may be compared with a preset voltage threshold, to determine whether a fault such as relay sticking exists on the main positive switch K2 or the pre-charging switch K3.

In other words, when at least two switch assemblies are connected in parallel, the at least two switch assemblies can multiplex the same group of first sampling branches (which may, for example, include the first sampling branch 20a and the first sampling branch 20b shown in FIG. 7), so that through multiplexing of the sampling branch, the circuit design can be simplified, and circuit costs can be reduced.

According to some embodiments of the present disclosure, the sampling module is connected to a high-voltage ground.

In this embodiment of the present disclosure, the sampling module is connected to the high-voltage ground, so that the issue of insulation withstand voltage no longer needs to be considered for the sampling module, and the voltage withstand rating selection for a switch device is relatively flexible. In addition, the sampling circuit belongs to a high-voltage region, and is no longer connected to a low voltage. In addition, interference immunity can be improved, and an isolation device does not need to be disposed, thereby reducing costs.

According to some embodiments of the present disclosure, the reference voltage module includes: a voltage source, the voltage source being configured to supply a second reference voltage; and a voltage conversion module, connected to the voltage source, and configured to convert the second reference voltage of the voltage source to provide corresponding sampling ranges for sampling detection points with different reference voltage requirements, respectively.

In this embodiment of the present disclosure, the voltage source is disposed to supply the second reference voltage, and then the second reference voltage is converted into different first reference voltages using the voltage conversion module, so that the reference voltage can be adjustable, and each sampling detection point can be sampled with respect to the first reference voltage or the second reference voltage, thereby satisfying different sampling requirements.

According to some embodiments of the present disclosure, the first reference voltage is less than the second reference voltage.

In this embodiment of the present disclosure, the first reference voltage is set to be less than the second reference voltage, so that large sampling ranges can be separately provided for a sampling detection point with a high voltage and a sampling detection point with a low voltage, thereby ensuring the accuracy of a sampling result.

According to some embodiments of the present disclosure, the voltage source is connected to a second terminal of the battery, and the second reference voltage is a voltage of an output voltage of the voltage source with respect to the second terminal of the battery.

In this embodiment of the present disclosure, the second terminal of the battery is used as a reference ground, so that the voltage source can supply the first reference voltage with respect to the second terminal of the battery to the reference sampling point.

According to some embodiments of the present disclosure, the sampling branches further include: a second sampling branch, connected to a first terminal of the battery and the voltage source, the voltage source being configured to supply the first reference voltage to the second sampling branch, where the sampling module is connected to a third end of the second sampling branch, and is configured to obtain a voltage at the first terminal of the battery with respect to the second terminal of the battery.

In this embodiment of the present disclosure, the second sampling branch can sample the voltage at the first terminal of the battery with respect to the second terminal of the battery, to directly obtain the terminal voltage of the battery, thereby implementing voltage sampling of the battery.

According to some embodiments of the present disclosure, the voltage conversion module includes: a first voltage division unit, the first voltage division unit being connected between the voltage source and the reference sampling point; and a voltage regulation unit, the voltage regulation unit being connected to the reference sampling point.

In this embodiment of the present disclosure, the first voltage division unit and the voltage regulation unit are disposed, so that the second reference voltage that is high can be clamped to output the first reference voltage that is low.

According to some embodiments of the present disclosure, the voltage conversion module further includes a second voltage division unit connected in parallel to the voltage regulation unit. In this way, the second voltage division unit can implement a voltage division function with the first voltage division unit, so that the voltage at the reference sampling point is kept from being excessively high when an abnormality, for example, an open circuit, occurs in the voltage regulation unit.

According to some embodiments of the present disclosure, the sampling branch includes: a first sampling unit and a second sampling unit, the first sampling unit and the second sampling unit being connected in series. In this way, the first sampling unit and the second sampling unit divide the voltage at the sampling detection point, so that the terminal voltage of the second sampling unit can fall within a sampling range of the sampling module.

According to some embodiments of the present disclosure, the sampling branch includes a first sampling point, and the sampling module includes a first sampling end; the first sampling point is disposed between the first sampling unit and the second sampling unit; and the first sampling point is connected to the first sampling end of the sampling module. In this way, in a conventional sampling manner with the arrangement that the first sampling end of the sampling module is connected to the first sampling point of the sampling branch, the voltage at the middle point between the first sampling unit and the second sampling unit can be directly sampled, and the voltage of the sampling detection point with respect to the reference sampling point can be determined with reference to a voltage division ratio of the first sampling unit to the second sampling unit.

According to some embodiments of the present disclosure, the sampling branch includes a second sampling point, and the sampling module includes a second sampling end; the second sampling point is disposed at two ends of the second sampling unit; and the second sampling point is connected to the second sampling end of the sampling module. In this way, in a differential sampling manner with the arrangement that the second sampling end of the sampling module is connected to the second sampling point of the sampling branch, so that the terminal voltage of the second sampling unit can be directly sampled, and the voltage of the sampling detection point with respect to the reference sampling point can be determined with reference to a voltage division ratio of the first sampling unit to the second sampling unit.

According to some embodiments of the present disclosure, the second sampling end of the sampling module is a differential sampling end. In this way, differential sampling is performed on the terminal voltage of the second sampling unit in a differential sampling manner, so that the terminal voltage of the second sampling unit can be directly obtained.

According to some embodiments of the present disclosure, the sampling branch further includes: a sampling control switch, the sampling control switch being connected between the first sampling unit and the second sampling unit, where the sampling control switch is configured to enable the sampling branch to be connected or disconnected. In this way, the sampling control switch can open the sampling branch when voltage sampling is not required, thereby saving resources.

According to some embodiments of the present disclosure, the plurality of switch assemblies include at least one first switch assembly and/or at least one second switch assembly, and the sampling branches include: a first terminal sampling branch, disposed corresponding to the first switch assembly, a sampling detection point corresponding to the first terminal sampling branch being connected to the first terminal of the battery by the first switch assembly; and a second terminal sampling branch, disposed corresponding to the second switch assembly, a sampling detection point corresponding to the second terminal sampling branch being connected to the second terminal of the battery by the second switch assembly. In this way, the first terminal sampling branch and the second terminal sampling branch may perform voltage sampling on a sampling detection point with a positive voltage and a sampling detection point with a negative voltage, respectively, and sampled voltages at the sampling detection points may be obtained, thereby implementing voltage sampling of a high-voltage loop.

According to some embodiments of the present disclosure, the first switch assembly includes any one of a main positive switch, a pre-charging switch, a main positive direct current charging switch, and a main positive alternating current charging switch, and the second switch assembly includes any one of a main negative switch and a main negative charging switch. In this way, voltage sampling is performed at each sampling detection point, and whether a sticking fault or another problem occurs on the switches may further be detected based on a sampling result, thereby implementing state diagnosis for the switch assemblies.

Based on the same inventive concept, the present disclosure further provides a battery pack. The battery pack includes a battery and the battery management system in any one of the foregoing embodiments. It may be understood that the battery pack has the beneficial effects of the battery management system provided in this embodiment of the present disclosure.

Based on the same inventive concept, the present disclosure further provides a power consuming apparatus. The power consuming apparatus includes the battery pack in any one of the foregoing embodiments. It may be understood that the power consuming apparatus has beneficial effects of the battery pack provided in the embodiments of the present disclosure. For details, refer to specific descriptions of the battery pack in the foregoing embodiments. Details are not described herein again in this embodiment.

It should be noted that the embodiments in the present disclosure and the features in the embodiments may be combined with each other without causing any conflict.

The functional blocks shown in the foregoing structural block diagrams may be implemented as hardware, software, firmware, or a combination thereof. When implemented in a hardware manner, the functional blocks may be, for example, an electronic circuit, an application-specific integrated circuit (ASIC), proper firmware, a plug-in, a functional card, or the like. When implemented in a software manner, an element of the present disclosure is a program or a code segment used for executing a required task. The program or code segment may be stored in a machine-readable medium, or transmitted on a transmission medium or a communication link by using a first data signal carried in a carrier. The "machine-readable medium" may include any medium that can store or transmit information. Examples of the machine-readable medium include an electronic circuit, a semiconductor memory device, a ROM, a flash memory, an erasable ROM (EROM), a floppy disk, a CD-ROM, an optical disc, a hard disk, a fiber optic medium, a radio frequency (RF) link, and the like. The code segment may be downloaded by using a computer network, for example, the Internet or an intranet.

It should be noted that, the terms "include", "comprise" or any variants thereof herein are intended to cover non-exclusive inclusion, such that a process, a method, an article or a device comprising a series of elements comprise not only those elements, but also other elements not listed explicitly, or elements inherent to this process, method, article or device.

Although the principle and implementations of the present disclosure are described by using specific examples in this specification, descriptions of the examples are merely intended to help understand the methods and core idea of the present disclosure. The foregoing descriptions are merely preferred implementations of the present disclosure. It should be noted that due to the inherent limitations of textual expression, while objectively an infinite variety of concrete structures exist, those of ordinary skill in the art may make several improvements, modifications, or variations without departing from the principles of the present disclosure, and may also combine the above technical features in an appropriate manner. All such improvements, modifications, variations, combinations, or the direct application of the concepts and technical solutions of the present disclosure to other scenarios without improvements shall be deemed as falling within the scope of protection of the present disclosure.

### Industrial Applicability

In this embodiment of the present application, the reference voltage module is disposed to supply the first reference voltage to the reference sampling point, so that the first sampling branch can be used to sample the voltage of the sampling detection point with respect to the reference sampling point. The sampling module may determine the voltage of each sampling detection point with respect to the reference sampling point, to implement voltage sampling on sampling detection points with different voltages. In addition, when a plurality of sampling detection points are provided, through the sharing of the same reference sampling point, a potential difference between any two sampling detection points may be calculated based on potential differences of the two sampling detection points with respect to the reference sampling point, thereby implementing circuit detection between the sampling detection points. In addition, when at least two switch assemblies are connected in parallel, the at least one switch assembly may further multiplex the same group of first sampling branches, thereby further simplifying the circuit design and reducing circuit costs.

## Claims

1. A battery management system, comprising:
a plurality of switch assemblies, each switch assembly being connected between a battery and a corresponding load, and configured to connect the battery to the corresponding load or disconnect the battery from the corresponding load;
a sampling circuit, the sampling circuit comprising sampling branches in a one-to-one correspondence with the plurality of switch assemblies, and each sampling branch being configured to acquire a voltage at a sampling detection point, wherein a first end of each sampling branch is connected to a corresponding switch assembly, and a connection point is the sampling detection point; a second end of each sampling branch is connected to a reference voltage module, and a connection point is a reference sampling point; and a third end of each sampling branch is connected to a sampling module;
the reference voltage module, configured to supply a first reference voltage to the reference sampling point; and
the sampling module, configured to obtain a voltage of each sampling detection point with respect to the reference sampling point, wherein
when the plurality of switch assemblies comprise switch assemblies connected in parallel, the sampling branches comprise two first sampling branches, one of the first sampling branches is connected to one end of the switch assemblies connected in parallel, and the other first sampling branch is connected to the other end of the switch assemblies connected in parallel.

2. The battery management system according to claim 1, wherein the sampling module is connected to a high-voltage ground.

3. The battery management system according to claim 1 or 2, wherein the reference voltage module comprises:
a voltage source, the voltage source being configured to supply a second reference voltage; and
a voltage conversion module, connected to the voltage source, and configured to convert the second reference voltage of the voltage source to provide corresponding sampling ranges for sampling detection points with different reference voltage requirements, respectively.

4. The battery management system according to claim 3, wherein the voltage source is connected to a second terminal of the battery, and the second reference voltage is a voltage of an output voltage of the voltage source with respect to the second terminal of the battery.

5. The battery management system according to claim 4, wherein the sampling branches further comprise:
a second sampling branch, connected to a first terminal of the battery and the voltage source, the voltage source being configured to supply the first reference voltage to the second sampling branch, wherein
the sampling module is connected to a third end of the second sampling branch, and is configured to obtain a voltage at the first terminal of the battery with respect to the second terminal of the battery.

6. The battery management system according to claim 3, wherein the voltage conversion module comprises:
a first voltage division unit, the first voltage division unit being connected between the voltage source and the reference sampling point; and
a voltage regulation unit, the voltage regulation unit being connected to the reference sampling point.

7. The battery management system according to claim 6, wherein the voltage conversion module further comprises a second voltage division unit connected in parallel to the voltage regulation unit.

8. The battery management system according to any one of claims 1 to 7, wherein the sampling branch comprises:
a first sampling unit and a second sampling unit, the first sampling unit and the second sampling unit being connected in series.

9. The battery management system according to claim 8, wherein the sampling branch comprises a first sampling point, and the sampling module comprises a first sampling end;
the first sampling point is disposed between the first sampling unit and the second sampling unit; and
the first sampling point is connected to the first sampling end of the sampling module.

10. The battery management system according to claim 8, wherein the sampling branch comprises a second sampling point, and the sampling module comprises a second sampling end;
the second sampling point is disposed at two ends of the second sampling unit; and
the second sampling point is connected to the second sampling end of the sampling module.

11. The battery management system according to claim 10, wherein the second sampling end of the sampling module is a differential sampling end.

12. The battery management system according to claim 8, wherein the sampling branch further comprises:
a sampling control switch, the sampling control switch being connected between the first sampling unit and the second sampling unit, wherein the sampling control switch is configured to enable the sampling branch to be connected or disconnected.

13. The battery management system according to any one of claims 1 to 12, wherein the plurality of switch assemblies comprise at least one first switch assembly and/or at least one second switch assembly, and the sampling branches comprise:
a first terminal sampling branch, disposed corresponding to the first switch assembly, a sampling detection point corresponding to the first terminal sampling branch being connected to the first terminal of the battery by the first switch assembly; and
a second terminal sampling branch, disposed corresponding to the second switch assembly, a sampling detection point corresponding to the second terminal sampling branch being connected to the second terminal of the battery by the second switch assembly.

14. The battery management system according to claim 13, wherein the first switch assembly comprises any one of a main positive switch, a pre-charging switch, a main positive direct current charging switch, and a main positive alternating current charging switch, and the second switch assembly comprises any one of a main negative switch and a main negative charging switch.

15. A battery pack, comprising a battery and the battery management system according to any one of claims 1 to 14.

16. A power consuming apparatus, comprising the battery pack according to claim 15.
